# EUROPEAN PATENT APPLICATION

(11) **EP 4 848 001 A1**
(43) Date of publication of application: **02.12.2026**
(21) Application number: 26181417.2
(22) Date of filing: 27.05.2026
(51) Int. Cl.: G03F 7/20

(54) **APPARATUS FOR EXPOSING A FLEXOGRAPHIC PRINTING PLATE WITH EXPOSURE LAMPS EACH COMPRISING TWO PRINTED CIRCUIT BOARDS WITH LEDS ELECTRICALLY CONNECTED IN SERIES**

(30) Priority: 28.05.2025 IT 202500012328
(71) Applicant: Vianord Engineering Sasu, 06510 Carros (FR)
(72) Inventor: SASSANELLI, Pier Luigi, 06800 Cagnes-sur-Mer (FR)
(74) Representative: De Bortoli, Tiziano

(57) **Abstract**

The present invention relates to an apparatus (1) for exposing a flexographic plate (5). The apparatus (1) comprises a lower part (10) supporting a rest plane (9) for said plate (5) and an upper part (11) supporting a plurality of exposure lamps (20, 20A, 20B) arranged on a lying plane (100), wherein said upper part (11) is rotatable with respect to said lower part (10). Each lamp (20, 20A, 20B) comprises a plurality of UV type LEDs (25A, 25B) aligned along a rectilinear direction (101), a lamp body (21) including a support base (22) and a transparent cover (23), wherein the lamp body (21) comprises a first cap (51) and a second cap (52), each comprising an electrical terminal (EP). According to the present invention, each lamp (20, 20A, 20B) comprises a first printed circuit (C1) mounted on said support base (22) and including a first group of LEDs (25A) of said plurality of LEDs, wherein said LEDs of said first group are electrically connected in series. Each lamp (20, 20A, 20B) further comprises a second printed circuit (C2) mounted on said support base (22) and comprising a second group of LEDs (25B) of said plurality of LEDs, wherein said LEDs of said second group are electrically connected in series. According to the invention, each printed circuit (C1, C2) is electrically connected to an electrical terminal (EP) of one of said caps (51, 52) and is electrically powered independently from the other of said printed circuits (C1, C2).

## Description

### FIELD OF THE INVENTION

The present invention falls within the field of apparatuses and systems for producing digital printing plates for flexography. More precisely, the present invention relates to an apparatus for exposing flexographic plates to light comprising LED lamps.

### STATE OF THE ART

Flexography, also known as flexographic printing or flexo, is a direct rotary printing method that uses relief matrices made of photopolymer materials. Such matrices, called printing plates, are of a flexible and soft type. They are wrapped around a printing cylinder, or impression cylinder, and inked. Printing is obtained by directly depositing ink on the substrate to be printed by means of a light pressure exerted by the cylinder on the printing substrate. Flexography is also a high-speed printing method that can be used to print on various types of substrates, which can be made of both absorbent and non-absorbent materials. Flexographic printing was initially used for producing paper and plastic bags, milk cartons, disposable cups and the like. However, thanks to the improved printing characteristics, this technology is now also used for printing newspapers, envelopes, labels, as well as printing on plastic, films, acetate sheets, wrapping paper and many other materials used in packaging.

In order to obtain good print quality, great care in preparing the flexographic plate is essential. This preparation comprises several steps including: a step of exposing the plate to ultraviolet (UV) light suitable for the photopolymerization thereof, a subsequent washing step, aimed at removing the unpolymerized portions, followed by a drying step and then a finishing step. To obtain the raised characters, the plate is polymerized only at specific portions of a mask which is impermeable to light, which have previously been made permeable to light. In particular, in the case of analog printing plates, a film is applied to the plate which reproduces, in negative, the image to be printed. In this case, the film acts as a mask. In the case of digital printing plates, instead, the photopolymer is initially covered by a surface layer of opaque material, i.e. a material impermeable to light, such as graphite. In this case, this surface layer acts as a mask and is therefore etched so as to create the negative of the image to be printed. The etching step is usually carried out using a computer-controlled digital laser. Exposing the plate to light causes the polymerization of only those parts of the plate located at the portions of the mask permeable to light, thus forming the image to be printed in relief on the photopolymer.

Subsequently, the flexographic plate is subjected to a washing step aimed at removing the portions of material that have not been exposed to light and are therefore not polymerized. This step can be carried out using a solvent which, by penetrating the polymer, dissolves the unpolymerized portions, or using water which causes a detachment of the unpolymerized portions, which are then removed using special brushes. As an alternative to solvent washing and water washing, a thermal type of washing can be used.

Subsequently, the plate is subjected to a drying step, normally carried out in a drying oven, in order to remove the water or solvent used in the washing step. Downstream of the drying oven, there is generally a finishing station, in which the flexographic plate is subjected to a finishing treatment.

The present invention relates to the photo-exposure step, which traditionally involved the use of conventional UV lamps. Over the past few years, UV lamps have been replaced by LED lamps, as described for example in patent documents WO 2013/156942 A1, US 2016/0229173 A1, EP 3121653 B1 and EP3811155. According to an established principle, the light exposure time varies with the intensity of the power radiated per unit of time and, secondarily, with the thickness of the plate.

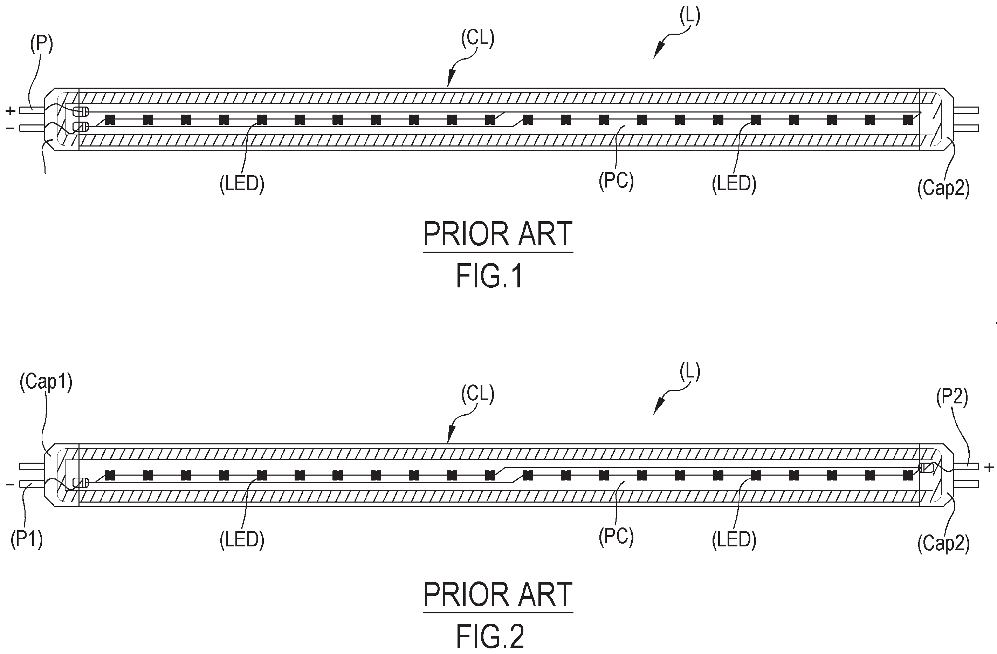

As shown in Figures 1 and 2, the exposure apparatuses based on LED technology normally include a plurality of lamps (L), each comprising a lamp body (CL) including a base and a transparent cover. For each lamp (L), a printed circuit board (PC) is provided which includes a plurality of LEDs aligned along a rectilinear direction. This printed circuit board (PC) is positioned on the base of the lamp body so that the LEDs face the transparent cover.

Each lamp (L) comprises two caps (Cap1, Cap2) mounted at the ends of the lamp body. These caps comprise a pair of metal pins (P; P1, P2) that allow connection to a support plane of the lamps of the exposure apparatus.

Typically, the LEDs are grouped into two groups powered in parallel through copper tracks built into the printed circuit board (PC). According to a first known configuration, schematically shown in Figure 1, the electrical power supply of the two groups of LEDs is achieved through a pair of pins (P) associated with the same cap (Cap1, Cap2), where this pair of pins acts as an electrical connector. Each pin (P) of the pair represents an electrical pole *(+ or -)*. It has been seen that following this arrangement, the voltage that reaches and powers the group of LEDs farthest from the electrical connector is lower than that applied to the electrical connector and which powers the group of LEDs closest to the connector itself. This voltage drop is due to the resistance of the copper tracks of the printed circuit board containing the LEDs. Disadvantageously, the voltage drop causes a difference in light emission, so that the LEDs in the group farthest from the electrical connector emit less light than the LEDs in the group closest to the electrical connector.

The resistance of the copper in the circuit board translates into increased temperatures, negatively impacting the lifespan of the LEDs. To limit this drawback, the trend is to increase the size *(dimensions and thickness)* of the copper tracks, i.e. to increase the dimensions of the printed circuit board. However, this solution has a negative impact on overall costs, also because the increase in the size of the printed circuit board requires an increase in the size of the support base of the lamp body and, more generally, of the lamp body.

According to a second known configuration, schematically shown in Figure 2, the power supply of the two groups of LEDs involves a first pin (P1) associated with a first (Cap1) of the two caps and a second pin (P2) associated with the second cap (Cap2). Each of these pins (P1, P2) constitutes an electrical pole *(+ or -)*.

It has been seen that each of the known configurations described above involves a specific installation method for the lamp, and therefore requires a certain degree of attention by the operators to respect the correct polarity of the power supply and avoid damage to the lamp circuit itself and/or its power supply.

A further critical issue is that the length of the power cables required to connect the power supply of a lamp *(external to the lamp body)* to the connectors *(i.e. to the two pins involved in the power supply)* of the lamp itself has to be the same for all lamps. In fact, a difference in length relative to a lamp would cause a voltage drop, whereby the light output generated by the lamp would be different from that of the other lamps.

### SUMMARY

In view of the above, a need clearly arises to provide an apparatus for exposing flexographic plates that allows the above-mentioned drawbacks relating to the prior art to be overcome or at least mitigated.

Within this task, a first object of the present invention is to provide an apparatus for exposing flexographic plates based on LED technology that allows uniform illumination while limiting voltage drops in the LED power supply circuit.

Another object of the present invention is to provide an apparatus for exposing flexographic plates which allows the operating life of the LEDs to be increased compared to traditional solutions.

Yet another object is to provide an apparatus for exposing flexographic plates that allows achieving a uniform illumination of the flexographic plate while still keeping the size of the lamp body to a minimum.

Not least object of the present invention is to provide an apparatus for the photo-exposition of a plate which is reliable and easy to manufacture at competitive costs.

The applicant has found that the above-mentioned task and objects can be achieved by dividing the LEDs of each lamp into two groups, providing a printed circuit board for each group of LEDs and electrically connecting the LEDs of each group in series, where each printed circuit board is electrically powered independently of the other. This arrangement allows reducing the current intensity required to power the LEDs, reducing the voltage drop and consequently obtaining more uniform lighting.

In particular, the above-mentioned task and objects are achieved through an apparatus for exposing a flexographic plate according to Claim 1. Preferred embodiments of the apparatus are specified in the dependent claims.

The apparatus for exposing a flexographic plate according to the present invention comprises:
- a lower part supporting a rest plane for said plate;
- an upper part supporting a plurality of exposure lamps arranged on a lying plane, wherein said upper part is rotatable with respect to said lower part and wherein each lamp comprises:
- a plurality of UV type LEDs aligned along a rectilinear direction;
- a lamp body including a support base and a transparent cover, said lamp body comprising a first cap and a second cap opposite to each other, wherein each cap comprises an electrical terminal.

The apparatus according to the invention is characterised in that each of said lamps comprises a first printed circuit mounted on said support base and including a first group of LEDs of said plurality of LEDs, wherein said LEDs of said first group are electrically connected in series. Each of said lamps further comprises a second printed circuit mounted on said support base and comprising a second group of LEDs of said plurality of LEDs, wherein said LEDs of said second group are electrically connected in series. According to the invention, each printed circuit is electrically connected to an electrical terminal of one of said caps and is electrically powered independently from the other of said printed circuits.

According to a possible embodiment, the first group of LEDs and the second group of LEDs have the same number of LEDs.

According to a possible embodiment, the LEDs of a first lamp are arranged in a position, evaluated according to a direction parallel to said rectilinear direction, which is offset with respect to the position of the LEDs of a second lamp adjacent to said first lamp.

According to a possible embodiment, at least one LED of said first lamp is arranged in a position, evaluated along said rectilinear direction, corresponding to the intermediate point of the distance between two LEDs of the adjacent second lamp.

According to a possible embodiment, for each of said lamps, a power supply is provided for each of said printed circuits, each power supply being arranged outside said lamp body and being electrically connected to the electrical terminal of one of said caps, each of said power supplies being electrically connected to an electrical power supply network.

Preferably, each power supply is connected to a control network that controls the operation of the power supply itself.

According to a possible embodiment, said upper part comprises a frame including a first installation side and a second installation side opposite to said first installation side, wherein said lamps are installed on said first installation side and wherein said power supplies are installed on said second installation side.

Preferably, the apparatus comprises ventilation means installed on the second installation side. According to a possible embodiment, the upper part of the apparatus comprises a cover removably connected to the frame on the second installation side.

According to a possible embodiment, the LEDs of the lamps are of the UVA or UVC type.

### LIST OF FIGURES

Further features and advantages of the present invention shall become clearer from the description of preferred, but not exclusive, embodiments of an apparatus for exposing a digital printing plate for flexography, illustrated by way of example in the attached drawings, wherein:
- Figures 1 and 2 are schematic views of LED lamp configurations of the prior art;
- Figure 3 is a schematic perspective view of a flexographic plate;
- Figures 4 and 5 are two perspective views of an apparatus according to the invention, respectively in a non-use configuration and in a use configuration.
- Figure 6 is a schematic view of a pair of lamps of an apparatus according to the present invention;
- Figure 7 is a schematic sectional view of an apparatus according to the invention;

In the figures, the same references are used to indicate the same elements or the same components.

### DETAILED DESCRIPTION

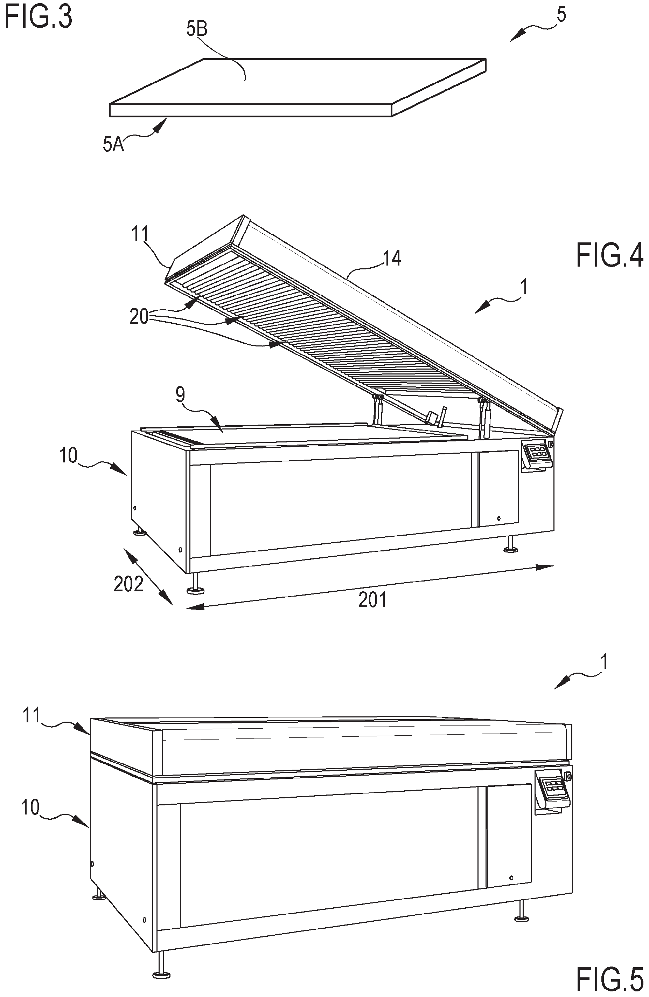

With reference to Figures 3 to 7, the present invention therefore relates to an apparatus for exposing a flexographic plate 5, generally indicated by reference number 1. In the plate 5, a first, base, surface 5A and a second surface 5B, opposite to said first surface 5A and intended for photo-exposure, can be identified *(see* *Figure 3**).*

The apparatus 1 comprises a lower part 10 supporting a rest plane 9 on which a flexographic plate 5 is intended to rest. The rest plane 9 is substantially horizontal. The plate 5 is arranged on the rest plane 9 so that its base surface 5A rests on the plane itself. Therefore, in use the second surface 5B is facing upwards.

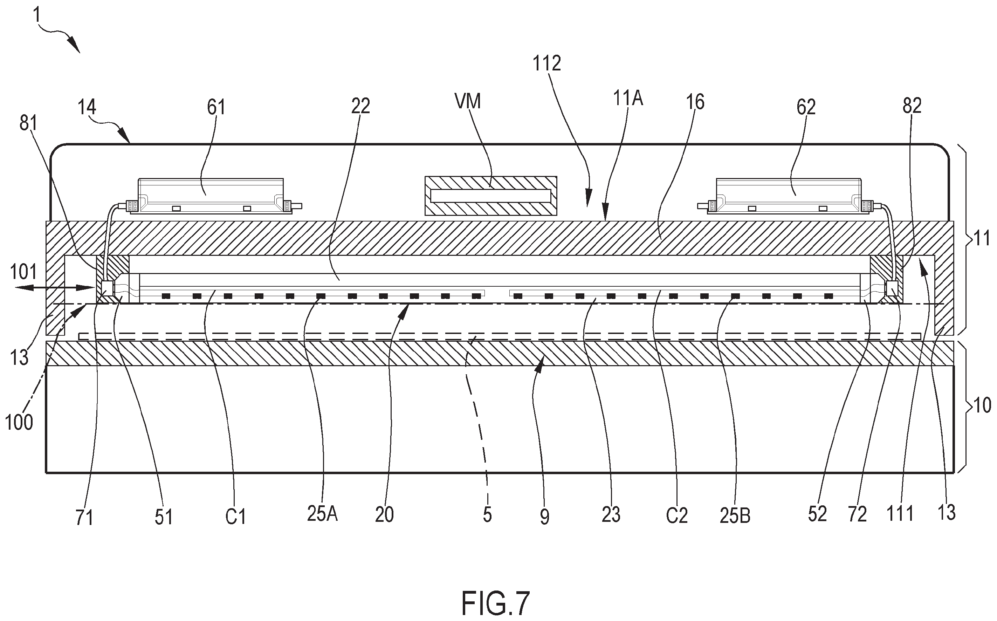

The apparatus 1 further comprises an upper part 11 supporting a plurality of lamps 20, 20A, 20B through which the photo-exposure is carried out. In particular, the lamps 20, 20A, 20B are arranged on a lying plane 100 *(indicated by a dashed line in* *Figure 7**)* which, at least in use, is parallel to the rest plane 9 of the lower part 10.

The terms "*lower*" and "*upper*" used in connection with the two parts 10, 11 of the apparatus 1 and more generally in the context of the present invention, must be considered with respect to a vertical direction and a use condition of the apparatus. Therefore, the upper part 11 is substantially located above the lower part 10.

With reference to Figures 4 and 5, according to a preferred embodiment, the upper part 11 is rotatably connected to the lower part 10 to rotate between a first reference position*,* wherein the lying plane 100 of the lamps 20, 20A, 20B is parallel to the rest plane 9, to a second reference position, wherein the lying plane 100 of the lamps 20, 20A, 20B is inclined with respect to the rest plane 9. The exposure of the plate 5 is carried out with the upper part 11 in the first reference position defined above. When the upper part 11 is in the second reference position, the rest plane 9 is accessible for positioning or removing the plate 5.

In the embodiment shown in the figures, the apparatus 1 has a substantially prismatic shape, extending along a longitudinal direction 201 and along a transverse direction 202 orthogonal to the longitudinal direction.

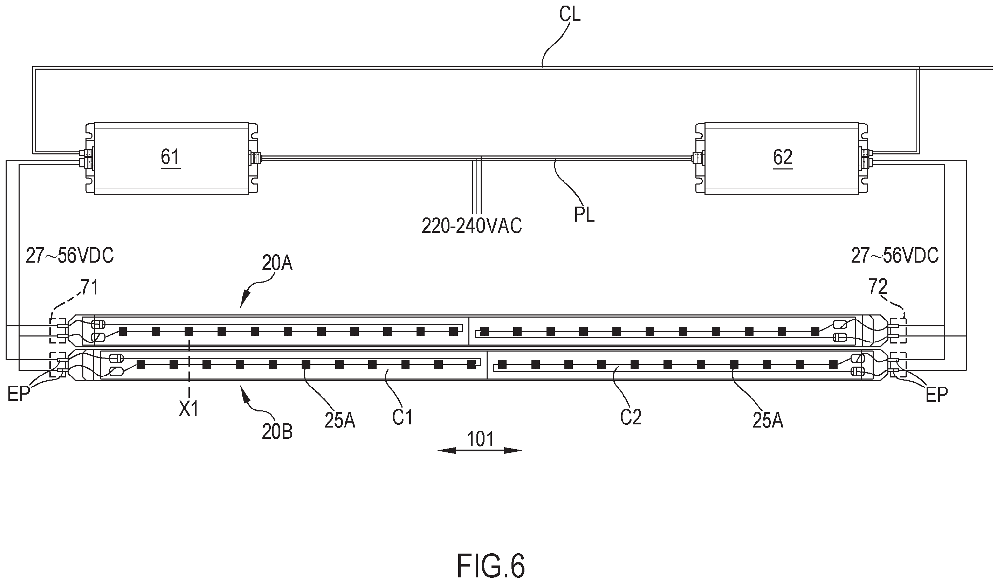

According to the invention, each lamp 20, 20A, 20B comprises a plurality of UV type LEDs 25A-25B aligned along a rectilinear direction 101 *(indicated in* *Figures 6* *and* *7**)*. Each lamp 20, 20A, 20B further comprises a lamp body 21 which extends along a longitudinal direction parallel to the rectilinear direction 101 of alignment of the LEDs 25A-25B. The lamp body 21 includes a support base 22 and a transparent cover 23 connected to the support base 22 so as to define an inner space where the LEDs 25A-25B are placed. The transparent cover 23 allows the diffusion of the light radiation generated by the LEDs 25A-25B, preferably without any filtering action. The support base 22 may comprise fins *(not shown in the figures)* to enhance dispersion of the thermal energy generated by the operation of the LED.

Each lamp 20, 20A, 20B further includes a first cap 51 and a second cap 52 each connected to one end of the lamp body 21. For each lamp 20, 20A, 20B, each cap 51, 52 comprises an electrical connector EP, preferably consisting of a pair of metal pins. Each electrical connector EP is configured to be electrically and mechanically connected to a further electrical connector 71, 72 external to the lamp 20, 20A, 20B, as better explained below. According to the present invention, each lamp 20, 20A, 20B comprises a first printed circuit C1 mounted on the support base 22 and including a first group of LEDs *(indicated by the reference 25A and hereinafter also with the expression first LEDs 25A)* of the plurality of LEDs 25A-25B. In particular, according to the invention the first LEDs 25A are electrically connected in series. According to the invention, each lamp 20, 20A, 20B further comprises a second printed circuit C2 mounted on the support base 22 and including a second group of LEDs (*indicated by the reference 25B and hereinafter also with the expression second LEDs 25B)* of the plurality of LEDs 25A-25B, wherein the second LEDs 25B are different from the first LEDs 25A. Similarly to LEDs 25A of the first group, the LEDs 25B of the second group are also electrically connected in series.

According to the present invention, each printed circuit C1, C2 is electrically powered through the electrical connector EP of one of the caps 51, 52 installed at the ends of the lamp body 21. Practically, each printed circuit C1, C2 is powered independently from the other through a specific connector EP associated with one of the two caps 51, 52. Therefore, the first LEDs 25A are powered independently from the second LEDs 25B. The splitting into two groups of independently powered LEDs advantageously allows limiting the current flowing through the LEDs, thereby reducing the heating thereof and increasing the lifespan thereof. This feature also leads to the possibility of using printed circuits C1, C2 with relatively limited thicknesses and therefore also limiting the dimensions of the components of the lamp body 21. The voltage drop is extremely low, allowing for more uniform illumination along the entire longitudinal extension of the lamp.

According to an embodiment, visible in the figures, the number of the first LEDs 25A is equal to the number of the second LEDs 25B. This solution contributes to a more uniform illumination provided by the lamps.

According to an embodiment, schematically shown in Figure 6, the lamps 20, 20A, 20B are arranged such that the LEDs 25A-25B of a first lamp 20A are in a longitudinal position offset with respect to the LEDs 25A-25B of a second lamp 20A adjacent to the same first lamp 20A. This arrangement is easily obtainable since the lamps 20, 20A, 20A have a same shape and do not have to be installed according to a predetermined polarity *(as instead required in some prior art solutions)*. By the term "*longitudinal position*" it is meant a position evaluated parallel to the rectilinear direction 101 of alignment of the LEDs 25A-25B.

Still referring to Figure 6, for each lamp 20, 20A, 20B, all LEDs 25A- 25B provided, except one, are arranged in a position corresponding to the intermediate point X1 of the distance between two LEDs 25A-25B of an adjacent lamp. It has been observed that this arrangement further improves the diffusion of light and the final quality of the exposure. Furthermore, as compared to traditional lamps, this expedient also allows the number of LEDs in each lamp to be reduced, keeping the length the same.

With reference again to Figure 6, a power supply 61, 62 arranged externally to the lamp body 21 is provided for each printed circuit C1 and C2. By the term "*external*" it is meant a condition wherein the power supplies 61, 62 are not part of the respective lamp 20, 20A, 20B, i.e. they are not supported and are not installed in any part thereof. Each lamp 20, 20A, 20B is therefore operatively associated with a pair of power supplies 61, 62, each connected to an electrical power supply network PL *(220-240 V).* Each power supply 61, 62 has the function of regulating the voltage and current intended for the LEDs *(first LEDs 25A or second LEDs 25B)* of the respective printed circuit board C1, C2.

Each power supply 61, 62 is connected to a control network CL that controls the operation of the power supply. In a possible configuration thereof, this control network is configured to operate according to the communication protocol known as DALI^{®}.

Figure 7 is a schematic sectional view of the two parts 10, 11 of the apparatus 1 and allows a preferred arrangement of the power supplies C1, C2 to be observed. In particular, in this figure the apparatus 1 is schematically shown in a use condition, in which the upper part 11 is in the first reference position whereby the lying plane 200 of the lamps 20 is parallel and adjacent to the rest plane 9 of the lower part 10.

The upper part 11 includes a frame 11A wherein a first installation side 111 and a second installation side 112 opposite to the first installation side 111 can be identified. As schematically shown, the frame 11A comprises a flat central plate 16. The first installation side 111 is defined by the lower surface *(hereinafter indicated by the same reference 111)* of plate 16, while the second installation side 112 is defined by the rear surface *(hereinafter indicated with the same reference 112)* of plate 16. Preferably, the frame 11A of the upper part 11 also includes a pair of sides 13 extending from said central plate 16 at opposite positions, whereby said frame 11A has a substantially C-shaped shape facing the lower part 10 of the apparatus 1 *(again considering the part 11 in the first reference position).*

The lamps 20, 20A, 20B are installed in a position adjacent to the first installation side 111 according to the lying plane 100 defined above. More precisely, each lamp 20, 20A, 20B is supported, at the caps 51, 52, by a pair of opposite supports 81, 82 *(indicated only in* *Figure 7**)* rising from the first installation side 111. Each support 81, 82 includes a further electrical connector 71, 72 *(indicated in* *Figures 6* *and* *7**)* which is electrically connected to the electrical connector EP associated with a corresponding cap 51, 52 of the lamps 20, 20A, 20B. Each of said further electrical connectors 72, 72 is electrically connected to a corresponding one of said power supplies 61, 62. Therefore, each power supply 61, 62 is electrically connected to the electrical connector EP associated with one of the caps 51, 52 and thus to the corresponding printed circuit C1, C2.

Still referring to Figure 7, for each lamp 20, 20A, 20B the power supplies 61, 62 are installed on the second installation side 112 of the frame 11A, i.e. on the upper surface of the plate 16. Preferably, each power supply 61, 62 is installed in a position close to a corresponding support 81, 82 of a lamp 20, 20A, 20B.

Overall, the number of power supplies 61, 62 is twice the number of lamps 20, 20A, 20B *(two power supplies for each lamp).* Preferably, the power supplies 61, 62 are arranged along two rows, each extending parallel to the longitudinal direction 201 of the apparatus 1 defined above. These rows are therefore spaced along the transverse direction 202 of the apparatus 1. Still with reference to Figure 7, the apparatus 1 comprises ventilation means VM installed on the second installation side 112 *(in this case again on the upper surface of the plate 16)* of the frame 11A for the purpose of cooling, by convection, the power supplies 61, 62 of the various lamps 20, 20A, 20B. In a preferred embodiment thereof, the ventilation means VM comprise a plurality of fans mutually spaced apart between the two rows of power supplies 61, 62 indicated above. This arrangement advantageously allows cooling all of the power supplies 61, 62.

Still referring to Figure 7, preferably the upper part 11 of the apparatus 1 comprises a cover 14 connected to the frame 11A on the second installation side 112 defined above. This cover 14 is removable to allow access to the frame 11A and particularly to the power supplies and ventilation means VM indicated above.

The solutions described above allow the abovementioned task and aims to be fully accomplished. In particular, the specific configuration of the LED lamps provided in the exposure apparatus according to the invention allows for a uniform diffusion of the generated light and therefore a higher final quality of the exposure, i.e. of the photopolymerization of the plate. At the same time, as compared to known solutions, the lifespan of the LED lamps is increased and overall manufacturing costs are reduced.

The materials used, as well as the dimensions and actual shapes, may vary according to needs and the state of the art.

## Claims

1. Apparatus (1) for exposing a flexographic plate (5) wherein said apparatus (1) comprises:
- a lower part (10) supporting a rest plane (9) for said plate (5);
- an upper part (11) supporting a plurality of exposure lamps (20, 20A, 20B) arranged on a lying plane (100), wherein said upper part (11) is rotatable with respect to said lower part (10) and wherein each of said lamps (20, 20A, 20B) comprises:
- a plurality of UV type LEDs (25A, 25B) aligned along a rectilinear direction (101);
- a lamp body (21) including a support base (22) and a transparent cover (23), said lamp body (21) comprising a first cap (51) and a second cap (52) opposite to each other, wherein each cap (51, 52) comprises an electrical terminal (EP),
**characterised in that** each of said lamps (20, 20A, 20B) comprises:
- a first printed circuit (C1) mounted on said support base (22) and including a first group of LEDs (25A) of said plurality of LEDs, wherein said LEDs of said first group are electrically connected in series;
- a second printed circuit (C2) mounted on said support base (22) and comprising a second group of LEDs (25B) of said plurality of LEDs, wherein said LEDs of said second group are electrically connected in series,
wherein each of said printed circuits (C1, C2) is electrically connected to the electrical terminal (EP) of one of said caps (51, 52) and is electrically powered independently from the other of said printed circuits (C1, C2).

2. Apparatus (1) according to claim 1, wherein for each lamp (20, 20A, 20B) said first group of LEDs (25A) and said second group of LEDs (25B) have the same number of LEDs.

3. Apparatus (1) according to any one of the preceding claims, wherein the LEDs of a first lamp (20A) are arranged in a position, evaluated according to a direction parallel to said rectilinear direction (101), which is offset with respect to the position of the LEDs of a second lamp (20B) adjacent to said first lamp (20A).

4. Apparatus (1) according to claim 3, wherein at least one LED of said first lamp (20A) is arranged in a position, evaluated along said rectilinear direction (101), corresponding to the intermediate point of the distance between two LEDs of the adjacent second lamp (20B).

5. Apparatus (1) according to any one of the preceding claims, wherein, for each of said lamps (20, 20A, 20B), a power supply (61, 62) is provided for each of said printed circuits (C1, C2), each power supply (61, 62) being arranged outside said lamp body (21) and being electrically connected to the electrical terminal (EP) of one of said caps (51, 52), each of said power supplies (61, 62) being electrically connected to an electrical power supply network (PL).

6. Apparatus (1) according to claim 5, wherein each power supply (61, 62) is connected to a control network (CL) that controls the operation of the power supply itself.

7. Apparatus (1) according to claim 5 or 6, wherein said upper part (11) comprises a frame (11A) including a first installation side (111) and a second installation side (112) opposite to said first installation side (111), wherein said lamps (20, 20A, 20B) are installed on said first installation side (111) and wherein said power supplies (61, 62) are installed on said second installation side (112).

8. Apparatus (1) according to claim 7, wherein said apparatus comprises ventilation means (VM) installed on said second installation side (112).

9. Apparatus (1) according to claim 7 or 8, wherein said upper part (11) comprises a cover (14) removably connected to said frame (11A) on said second installation side (112).

10. Apparatus (1) according to any one of the preceding claims, wherein sad LEDs are of the UVA o UVC type.
